(19) Europäisches Patentamt
European Patent Office
Office européen des brevets

(11) EP 4 760 770 A1

(12) EUROPEAN PATENT APPLICATION

(43) Date of publication:
17.06.2026 Bulletin 2026/25

(21) Application number: 24219215.1

(22) Date of filing: 11.12.2024

(51) International Patent Classification (IPC):
H01J 37/22 (2006.01)          H01J 37/26 (2006.01)
H01J 37/28 (2006.01)

(52) Cooperative Patent Classification (CPC):
H01J 37/228; H01J 37/263; H01J 37/28;
H01J 2237/0047; H01J 2237/0048

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: ASML Netherlands B.V.
5500 AH Veldhoven (NL)

(72) Inventors:
• DE LEON ARIZPE, Israel
  5500 AH Veldhoven (NL)
• SAHIN, Ezgi
  5500 AH Veldhoven (NL)
• VAN T WESTEINDE, Maaike
  5500 AH Veldhoven (NL)

(74) Representative: ASML Netherlands B.V.
Corporate Intellectual Property
P.O. Box 324
5500 AH Veldhoven (NL)

(54) **OPTICAL BEAM MEMBER**

(57) An optical beam member is for a charged particle-optical device configured to direct a charged particle beam along a charged particle-optical axis of the charged particle-optical device and towards a sample location. The optical beam member comprises a plurality of emitter arrangements configured to emit respective optical beams towards the sample location. A first beam aperture is defined in the optical beam member for passage of the charged particle beam towards the sample location. The plurality of emitter arrangements are arranged adjacent the first beam aperture and are configured to emit the respective optical beams to form a combined optical beam towards the sample location.

Fig. 8

EP 4 760 770 A1

**Description**

FIELD

The present invention relates to an optical beam member, an assembly, a charged particle-optical device, a charged particle-optical apparatus and a method for directing optical beams.

BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

When the primary beam scans the sample, charges may be accumulated on the sample due to large beam current, which may affect the quality of the image. There is therefore a need to improve the defect contrast during defect inspection.

SUMMARY

It is an object of the present disclosure to provide embodiments that enable the intensity of the light beam on the beam spot of the primary beam on the sample to be increased.

According to a first aspect of the invention, there is provided an optical beam member for a charged particle-optical device configured to direct a charged particle beam along a charged particle-optical axis of the charged particle-optical device and towards a sample location, the optical beam member comprising:

a plurality of emitter arrangements configured to emit respective optical beams towards the sample location, wherein a first beam aperture is defined in the optical beam member for passage of the charged particle beam towards the sample location; wherein the plurality of emitter arrangements are arranged adjacent the first beam aperture and are configured to emit the respective optical beams to form a combined optical beam towards the sample location.

According to a second aspect of the invention, there is provided a method for directing optical beams towards a sample, the method comprising:

emitting, from a plurality of emitter arrangements of an optical beam member of a charged particle-optical device configured to direct a charged particle beam along a charged particle-optical axis of the charged particle-optical device and towards a sample, respective optical beams towards the sample, wherein a first beam aperture is defined in the optical beam member for passage of a charged particle beam towards the sample; wherein the emitter arrangements are adjacent the first beam aperture and emit respective optical beams that form a combined optical beam towards the sample.

BRIEF DESCRIPTION OF THE DRAWINGS

Embodiments of the invention will now be described, by way of example only, with reference to the accompanying schematic drawings, in which:

- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;

- Figure 4 schematically depicts an alternative multi-beam charged particle-optical device, for example of the assessment apparatus of Figure 1;
- Figure 5 schematically depicts a charged particle-optical device array;
- Figure 6 schematically depicts a detector array in plan view;
- Figure 7 schematically depicts a detector element in cross-section;
- Figure 8 schematically depicts an assembly for a charged particle-optical device;
- Figure 9 is a simulation showing the intensity of a combined optical beam as a function of location above a sample;
- Figure 10 is a simulation showing the intensity of a combined optical beam as a function of location of the sample;
- Figure 11 schematically depicts an assembly for a charged particle-optical device, for example of the type shown in Figure 3 or Figure 4;
- Figure 12 schematically depicts an exemplary plan view of an optical beam member, for example of the assembly shown in Figure 8;
- Figure 13 schematically depicts an assembly for comparison with the assembly shown in Figure 8;
- Figure 14 is a simulation showing the intensity of the optical beam shown in Figure 13 as a function of location above the sample; and
- Figure 15 is a simulation showing the intensity of the optical beam as a function of location on the sample.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

## DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

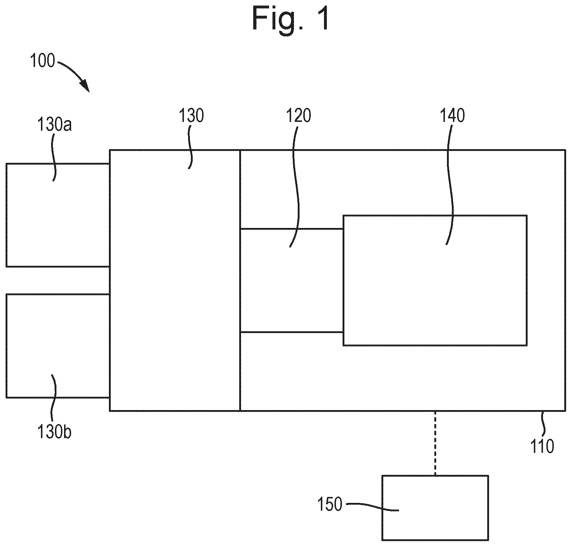

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

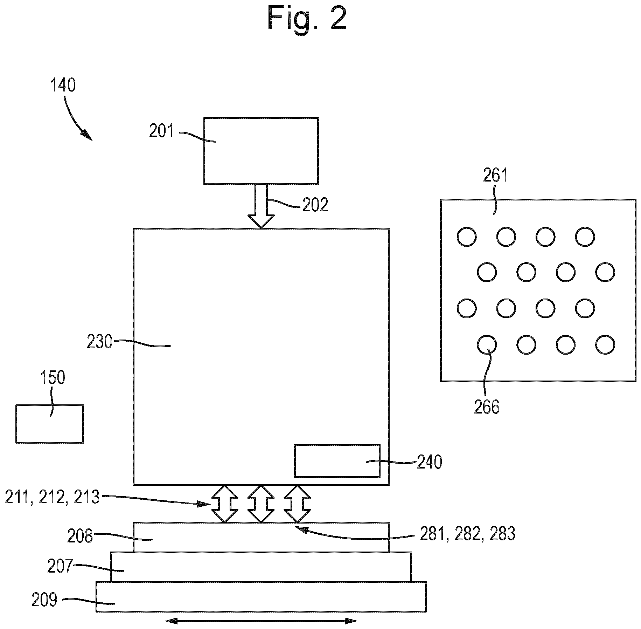

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

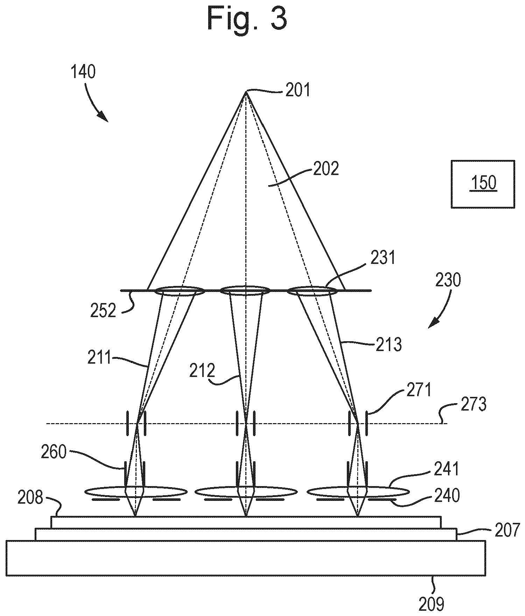

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

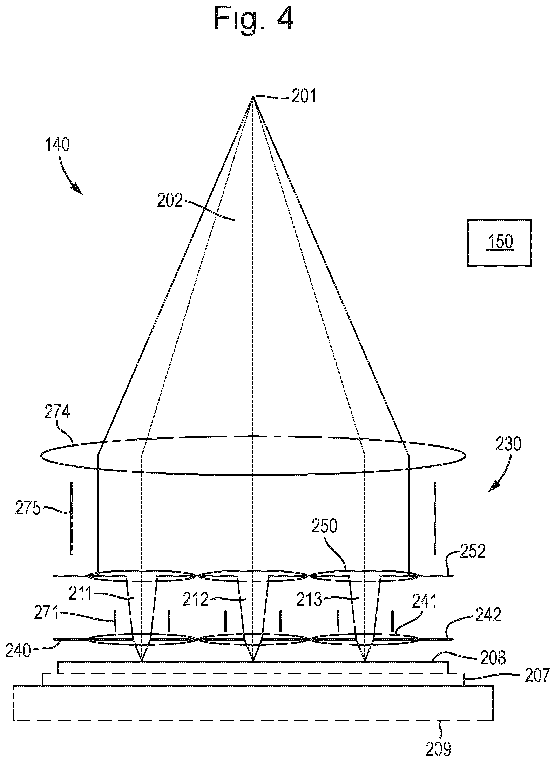

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266.

One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

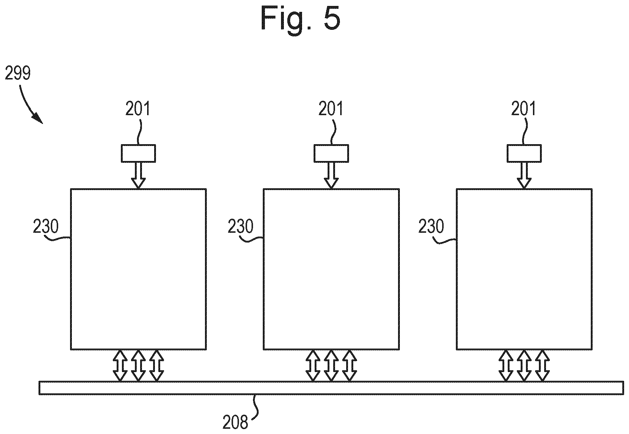

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

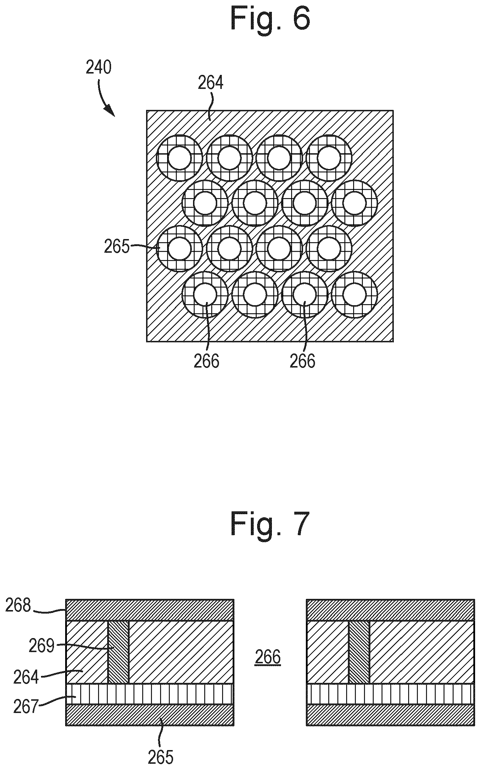

Figure 6 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 6, the beam apertures 266 are in a hexagonal close packed array. The beam apertures 266 can also be differently arranged, e.g. in a rectangular array.

Figure 7 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 may include control lines, data lines and power lines. It will be noted that in spite of the beam apertures 266 there is ample space for all necessary connections. The detector array 240 may be fabricated using CMOS technology, but may also be fabricated using bipolar or other manufacturing techniques. A printed circuit board and/or other semiconductor chips may be provided on the detector array 240.

In order to improve defect contrast during defect inspection, the sample 208 may be illuminated with optical radiation, for example light, before or during assessment of the sample with charged particles, for example electron beam(s). Voltage contrast-defect inspection, may be used to assess as to whether there is a proper electrical connection between a contact and a substrate of the sample 208. Depending on the signal electron yield (<1 or >1) the contact to the N+ or P+ doped region on the substrate forms a diode in reverse. As a result, it can be the case that it is not possible to distinguish between a proper and a bad electrical connection for either the N+ or the P+ contacts. By illuminating the sample 208 with light, the diode in reverse is made conductive. As a result, the contact will not charge in case there is a proper electrical connection between contact and substrate, but it will charge in case the electrical connection is bad. This technique of improving defect contrast by illuminating the sample with light, for example, during inspection of the sample is referred to as advanced charge control (ACC).

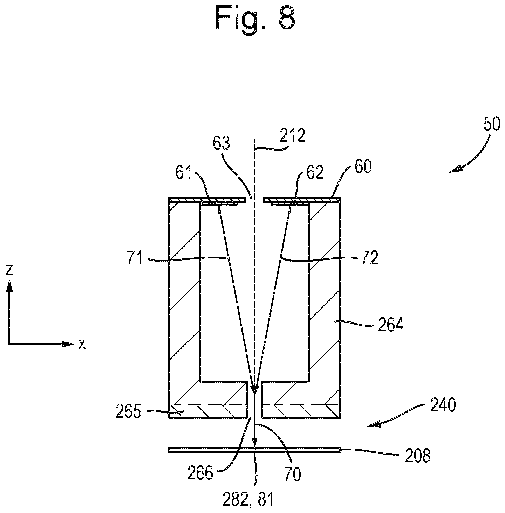

Figure 8 schematically depicts an assembly 50. The assembly 50 is part of an electron-optical device 230. For example, the assembly 50 may be comprised in an electron-optical device 230 of the type shown in Figure 3 or Figure 4, for example. As another example, the assembly 50 may be comprised in an electron-optical device 230 that is configured to direct a single electron beam (rather than a plurality of electron beams) towards a sample 208. In other words, the assembly 50 may be used in either a single beam electron-optical apparatus 140 or a multi-beam electron-optical apparatus 140. The electron beam(s) may be directed along an electron-optical axis of the electron-optical device 230. As shown in Figure 8, in an embodiment the assembly 50 comprises an optical beam member 60 which may be part of an ACC module. The optical beam member 60 is configured to emit optical beams 71, 72 towards the sample 208. As shown in Figure 8, the optical beam member 60 is located upbeam of the sample 208. The optical beam member 60 is configured to illuminate the sample 208 with optical beams or optical radiation, for example, light beams. In one embodiment the light beams can be in the visible wavelength range. In an embodiment, the optical beam member 60 is configured to emit the optical beams for improving defect contrast as described above.

As shown in Figure 8, in an embodiment, a first beam aperture 63 is defined in the optical beam member 60. The first beam aperture 63 is for passage of an electron beam 212 towards the sample 208. In the arrangement shown in Figure 8, the electron beam 212 is directed substantially vertically downwards onto the sample 208. The electron-optical axis of the assembly 50 may be substantially perpendicular to the surface of the sample 208.

As shown in Figure 8, the optical beam member 60 may form part of the electron-optical device 230, that is part of the electron-optical column. The optical beam member 60 may be configured to emit optical beams 71, 72 that reach the sample 208 through the same apertures used for the passage of the electron beam 212. In an embodiment the optical beam member 60 is integrated with the electron-optical device 230. The optical beams 71, 72 may be directed towards a sample location through the electron-optical device 230.

As shown in Figure 8, in an embodiment the optical beam member 60 comprises a plurality of emitter arrangements 61, 62. The emitter arrangements 61, 62 are configured to emit respective optical beams 71, 72 towards the sample 208. In an embodiment the emitter arrangements 61, 62 are adjacent the first beam aperture 63.

For example, Figure 8 shows a first emitter arrangement 61 configured to emit a first optical beam 71 towards the sample 208. Figure 8 further shows a second emitter arrangement 62 configured to emit a second optical beam 72 towards the sample 208. Although only two emitter arrangements 61, 62 and two optical beams 71, 72 are shown in Figure 8, the optical beam member 60 may comprise more than two emitter arrangements configured to emit more than two optical beams. For example, the optical beam member 60 may comprise three emitter arrangements, four emitter arrangements or more than four emitter arrangements configured to emit respective optical beams towards the sample 208.

As mentioned above, the assembly 50 may be used in the context of an electron-optical device 230 configured to direct a plurality of electron beams 211, 212, 213 towards the sample 208. In an embodiment the optical beam member 60 comprises, for each electron beam 211, 212, 213, a plurality of emitter arrangements 61, 62 configured to emit respective optical beams 71, 72 towards the sample 208. For example, the optical beam member 60 may comprise at least two emitter arrangements, optionally at least three emitter arrangements and optionally at least four emitter arrangements per electron beam.

As shown in Figure 8, in an embodiment the assembly 50 comprises an aperture element. In an embodiment the aperture element is an aperture plate. However, it is not essential for the aperture element to be an aperture plate. In the arrangement shown in Figure 8, the aperture element comprises the detector substrate 264 and the detector element 265. Embodiments are described primarily in the context of the aperture element comprising the detector substrate 264 and the detector element 265. However, it is not essential for the aperture element to comprise the detector substrate 264 or the detector element 265. The aperture element may have a different function from the detector 240. For example, the aperture element may be a spacer configured to mechanically space other components from each other. Alternatively the aperture element maybe an electrode.

In an embodiment the aperture element is located between the optical beam member 60 and the sample 208. The aperture element may be disposed downbeam of the optical beam member 60.

As shown in Figure 8, in an embodiment a second beam aperture 266 is defined in the aperture element (e.g. in the detector substrate 264 and the detector element 265). The second beam aperture 266 is for passage of the electron beam 212 towards the sample 208. In an embodiment the first beam aperture 63 is substantially aligned with the second beam aperture 266. The electron beam 212 passes through both the first beam aperture 63 and the second beam aperture 266.

As shown in Figure 8, in an embodiment the emitter arrangements 61, 62 are configured to emit optical beams 71, 72 that pass through the second beam aperture 266 towards the sample 208. The optical beams 71, 72 pass through the same beam aperture 266 through which the electron beam 212 passes. In an embodiment the plurality of emitter arrangements 61, 62 are configured to emit the respective optical beams 71, 72 that form the combined optical beam 70, substantially at or near the second beam aperture 266. The combined optical beam 70 may have a focal point at or adjacent to the second beam aperture 266.

As shown in Figure 8, the angle between a direction of the electron beam 212 (or the electron-optical axis or the normal to plane (x-y) containing the optical member 60) and the direction of each of the optical beams 71, 72 is close to normal. This angle may be referred to an emission angle of each emitter arrangement. As seen in Figure 8, the electron beam 212 passes along an electron-optical axis (not shown) of the assembly 50 where the electron-optical axis can be understood as an axis passing through a geometrical center of apertures in the assembly which enable passage of the electron beam. For example, it is the axis which passes through a geometric center of the aperture 63 and aperture 266, where aperture 266 is substantially aligned with aperture 63 to enable the passage of electron beam 212. Therefore, the emission angle of each of the optical beams 71, 72 emitted by the respective gratings 61, 62 can also be defined with respect to the electron-optical axis. In an embodiment, the angle between a direction of the electron beam 212 (or electron optical axis) and the direction of each of the optical beams 71, 72 is at least one degree, optionally at least two degrees, optionally at least five degrees, and optionally at least seven degrees. In an embodiment the angle between a direction of the electron beam 212 and the direction of each of the optical beams 71, 72 is at most twenty degrees, optionally at most ten degrees, optionally at most eight degrees and optionally at most five degrees. The power of each optical beam 71, 72 may be relatively concentrated on the sample 208. An embodiment of the invention is expected to increase the peak intensity of the light beam spot in a scan region by the electron beam 212 on a sample location.

As shown in Figure 8, in an embodiment the optical beams 71, 72 are configured to form a combined optical beam 70. The combined optical beam 70 is formed from the optical beams 71, 72 emitted by the emitter arrangements 61, 62 of the optical beam member 60. The power of the combined optical beam 70 may be greater than the power of each of the first optical beams 71 and the second optical beam 72 individually.

As shown in Figure 8, in an embodiment the emitter arrangements comprise a first pair of emitter arrangements 61, 62 at opposite sides, in a first direction, of the first beam aperture 63. In the arrangement shown in Figure 8, the first emitter arrangement 61 and the second emitter arrangement 62 may form a first pair of emitter arrangements 61, 62. As shown in Figure 8, in an embodiment the first emitter arrangement 61 is located to the --X side of the first beam aperture 63 in the optical beam member 60. The second emitter arrangement 62 is located at the +X side of the first beam aperture 63. The first pair of emitter arrangements 61, 62 are provided at opposite sides of the first beam aperture 63 in the X direction.

In an embodiment, the first emitter arrangement 61 and the second emitter arrangement are symmetrically arranged with respect to the first beam aperture 63 or the electron-optical axis of the first beam aperture 63. In other embodiments, the pair of emitter arrangements 61, 62 may have a different arrangement with respect to the first beam aperture 63.

By providing the emitter arrangements 61, 62 at opposite sides of the first beam aperture 63, the intensity of the combined optical beam 70 may be maximised at or adjacent to a center of the second beam aperture 266. In an embodiment the optical beam member 60 is configured such that the emitter arrangements 61, 62 emit optical beams 71, 72 that form a combined optical beam 70 at or adjacent the sample 208 - for example, adjacent the detector or second beam aperture 266 as shown in Figure 8. The corresponding combined optical beam spot 81 is then formed at the sample 208. That is, the combined optical beam spot is formed where the combined optical beam 70 is incident on the surface of the sample 208. The electron beam 212 may impinge the sample at a sample location to form an electron beam spot 282 at a sample location on the sample 208. As shown in Figure 8, in an embodiment the assembly 50 is configured such that the combined optical beam spot substantially coincides with the electron beam spot 282 on the sample 208. The assembly 50, in particular, the substantially symmetric arrangement of the emitter arrangements 61, 62 adjacent the first beam aperture 63 (for example, with respect to the electron-optical axis through the first beam aperture 63), enables the maximization of the intensity of the combined optical beam spot 81 at the sample location where the electron beam impinges the sample, that is, where electron beam spot 282 is formed. However, it is not essential for the combined optical beam spot of the combined optical beam 70 to precisely coincide with the electron beam spot 282 of the electron beam 212. A centre of the electron beam spot 282 may be distanced from a centre of the combined optical beam spot of the combined optical beam 70. In an embodiment, the combined optical beam spot at least partially overlaps with the electron beam spot 282.

Even when the combined optical beam spot does not precisely coincide with the electron beam spot 282, the combined optical beam spot may be closer to the electron beam spot 282 than would be the case if only one of the first emitter arrangement 61 and the second emitter arrangement 62 were to emit an optical beam to the sample 208. In an embodiment an optical beam spot corresponding to the combined optical beam 70 is substantially proximal to a charged particle beam spot corresponding to the region where the electron beam impinges the sample 208 or the scan region of the electron beam spot 282 on the sample 208. In an embodiment an optical beam spot on the sample 208 is substantially coincident with the electron beam spot 282. An embodiment of the invention is expected to improve coincidence between the electron beam spot 282 and an area of the sample 208 illuminated by a light beam. An embodiment of the invention is expected to improve enhancement of voltage contrast measurements. An embodiment of the invention is expected to improve accuracy of assessment of a sample 208.

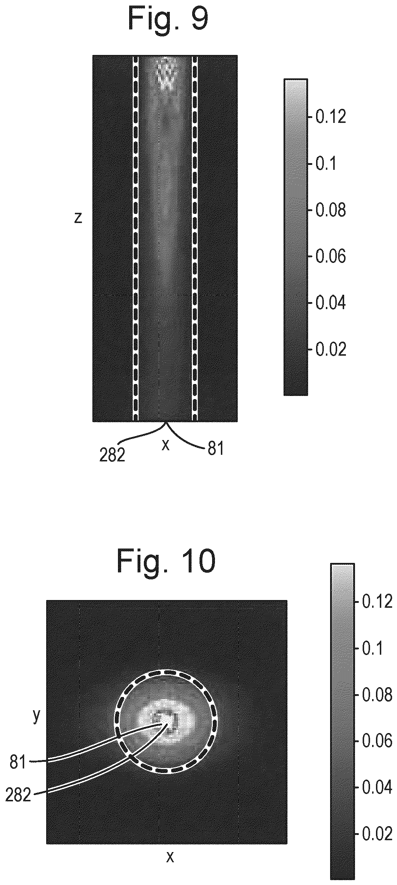

Figure 9 is a simulation of the optical intensity distribution in the region between the bottom-most element, 265, of assembly 50and the sample 208, in a plane (X-Z) perpendicular to the sample plane (X-Y) when the dual emitter arrangement 61, 62 shown in Figure 8 is implemented. Figure 9 shows an intensity scale in the units W/m$^2$. As shown in Figure 9, in an embodiment, by implementing the dual arrangement of the pair of emitter arrangements 61, 62 as shown in Figure 8, the intensity of the combined optical beam 70 is maximised at a location which coincides with the electron beam 212. This helps to increase the enhancement of the voltage contrast by the illumination of the sample 208 with the light beam.

Figure 10 is a simulation of the optical intensity distribution in the sample (X-Y) plane when the when the dual emitter arrangement 61, 62 shown in Figure 8 is implemented. Figure 10 shows an intensity scale in the units $W/m^2$. As shown in Figure 10, the combined optical beam spot 81 may be substantially coincident with the electron beam spot 282. In other embodiments, the emitter arrangements 61, 62 may be configured such that the optical beam spot 81 is not necessarily coincident but still substantially overlaps with the electron beam spot to enable voltage contrast defect inspection.

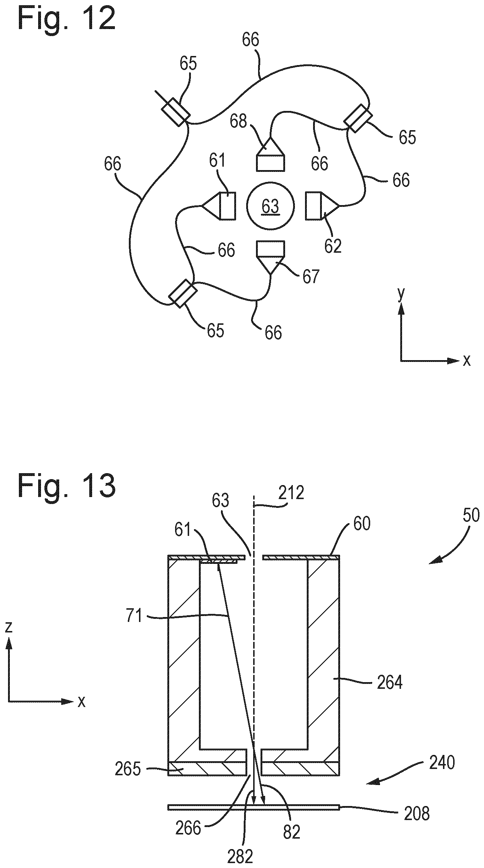

Figure 13 shows a comparative example of an assembly 50 having a single emitter arrangement arranged adjacent the aperture 63. That is, in the assembly 50 shown in Figure 13, the optical beam member 60 comprises only the first emitter arrangement 61. Only one optical beam 71 is output through the second beam aperture 266. As seen in Figure 13, the optical beam 71 propagates towards the sample in an oblique propagation direction. As shown in Figure 13, the corresponding optical beam spot 82 on the sample is distanced from or displaced away from the electron beam spot 282 on the sample.

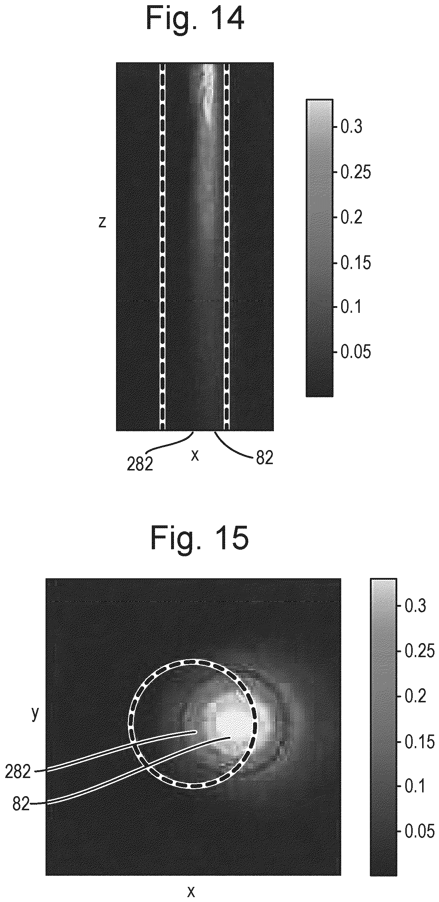

Figure 14 shows the full wave electromagnetic simulation of the optical intensity distribution in the region between the bottom-most element, 265, of assembly 50 and the sample 208, in a plane (X-Z) perpendicular to the sample plane (X-Y) when the single emitter arrangement 61 shown in Figure 13 is implemented. Figure 14 shows an intensity scale in the units $W/m^2$. Figure 15 shows the full wave electromagnetic simulation of the optical intensity of the optical beam 71 in the sample (X-Y plane), when the single emitter arrangement 61 shown in Figure 13 is implemented. Figure 15 shows an intensity scale in the units $W/m^2$. As shown in Figure 14 the optical beam 71 is displaced away from (not centred on) the electron beam 212 i.e. the electron-optical axis and the corresponding maximum intensity of the optical beam spot 82 on the sample is displaced away the electron beam spot 282 on the sample.

The dual emitter arrangement in Figure 8 advantageously requires less output power per emitter arrangement (61, 62) for enabling voltage contrast defect inspection when compared to a single emitter arrangement 61 in Figure 13. Also, an intensity of the combined optical beam spot 81 in Figure 8 is substantially coincident with the electron beam spot 282 or a scan region of an electron beam spot 282 on the sample, and is higher than an intensity of the optical beam spot 82 corresponding to beam 71 on sample 208 in Figure 13. Therefore, the arrangement in Figure 8 provides improved voltage contrast defect inspection when compared to the arrangement in Figure 13.

As mentioned above, the optical beam member 60 may comprise more than two emitter arrangements 60, 61 per electron beam 212. For example, the optical beam member 60 may comprise three emitter arrangements around the first beam aperture 63. The three emitter arrangements may be substantially evenly distributed around the first beam aperture 63. For example, there may be, in plan view (or in the plane containing the optical member 60 with the emitter arrangements), 120° between the emitter arrangements. In general, for N emitter arrangements, the emitter arrangements may be distributed such that in plan view (or in the plane containing the optical member 60 with the emitter arrangements) there is an angle of 360°/N between the emitter arrangements. By evenly distributing the emitter arrangements, the intensity of the combined optical beam 70 may be better aligned or centred on the electron beam spot 282. By providing more than two emitter arrangements 61, 62, the combined optical beam spot 81 may be better centred on the field of the sample 208 in two dimensions.

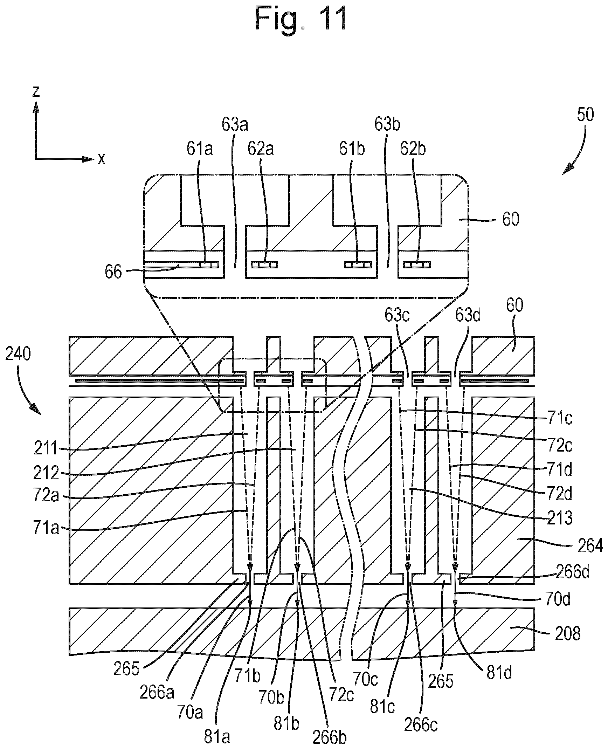

Figure 11 schematically depicts an assembly 50. The assembly 50 may have the same features as described with reference to Figure 8. In the arrangement shown in Figure 11, the assembly 50 is for an electron-optical device 230 configured to direct a plurality of electron beams 211, 212, 213 towards the sample 208.

As shown in Figure 11, in an embodiment a plurality of first beam apertures 63 (a-d) are defined in the optical beam member 60 for passage of respective electron beams towards the sample 208. For exemplary purposes, only four first beam apertures 63 (a-d) are shown in Figure 11. However, the number of first beam apertures 63 (a-d) may be substantially the same as the number of electron beams 211, 212, 213. This may be referred to as an assembly for a multi-beam system. Figure 11 shows a close up view of two of the first beam apertures 63 (a,b).

As shown in Figure 11, in an embodiment a plurality of corresponding second beam apertures 266 (a-d) are defined in the aperture element (e.g. detector substrate 264 and/or detector elements 265) for passage of the respective electron beams 211, 212, 213 towards the sample 208.

As shown in Figure 11, in an embodiment the optical beam member 60 comprises, for each first beam aperture 63 (a-d) or equivalently for each second beam aperture 266 (a-d), a respective plurality of emitter arrangements 61(a-d), 62 (a-d) configured to emit optical beams 71 (a-d), 72 (a-d) which in turn combine to form respective combined optical beams 70 (a-d) to pass through the respective second beam aperture 266 (a-d) towards the sample 208. As seen in Figure 11, each of the respective combined optical beams 70a-d impinge the sample at corresponding optical spots 81(a-d) which are substantially coincident with the corresponding electron beams 211-213. In another embodiment, the plurality of emitter arrangements (61,62) may be provided for, or associated with, each first beam aperture of a subset of the plurality of first beam apertures in the optical members. In an embodiment the optical beam member 60 comprises, for each first beam aperture of a subset of the first beam apertures 63 (a-d) or equivalently for each second beam aperture of a subset of the second beam apertures 266 (a-d), a respective plurality of emitter arrangements 61(a-d), 62 (a-d) configured to emit optical beams 71 (a-d), 72 (a-d) which in turn combine to form respective combined optical beams 70 (a-d) to pass through the respective second beam aperture 266 (a-d) towards the sample 208.

In an embodiment the optical beam member 60 comprises a photonic integrated circuit (PIC) having the emitter arrangements 61, 62 and the first beam apertures. The emitter arrangements 61, 62 may comprise grating couplers configured to emit the optical beams 71, 72 towards the sample. For example, the PIC may further comprise waveguides to couple light from an external source and direct it towards the grating couplers 61, 62 for emission or out-coupling of the optical beams 71, 72 towards the sample 208. The external optical source may be a coherent source, for example, a laser source. In an embodiment, the optical beam member 60 comprises a substrate, for example a silicon substrate, in which the first beam apertures 63 are defined. The first beam apertures 63 may be formed through the silicon substrate and a waveguide layer comprising the waveguides. In some embodiments, the substrate may be a non-optical substrate. In a preferred embodiment, the PIC comprises waveguides configured to couple light from an external coherent source into each grating coupler 61, 62. In one embodiment, the PIC is configured such that light injected into one grating coupler 61 is in-phase with light injected into the other grating coupler 62. For example, one or more parameters of the waveguides (such as a length of the waveguides) feeding light into the grating couplers may be configured to ensure that light exiting the waveguide and then injected in to the grating couplers has the same phase.

In an embodiment each emitter arrangement comprises a periodic structure such as a grating coupler as described above. The periodic structure may be a diffraction grating. The periodic structure may be configured such that photons are emitted at each of a plurality of repeating structures across the periodic structure. The emitter arrangement may be an array of periodic or semi- or quasi-periodic emitter structures. The photons emitted from the plurality of repeating structures form the optical beam emitted from the emitter arrangement.

In an embodiment the emitter arrangements 61, 62 are configured for asymmetric coupling. With respect to a centerline or optical axis through an input waveguide 66, the emission profile of the emitter arrangement on one side of the centerline may be different from an emission profile of the emitter arrangement on the other side of the centerline. The emitter arrangement may be configured to predominantly emit (directional emission) towards the sample 208. In an embodiment, the emitter arrangements may be focusing emitter arrangements.

Figure 12 schematically depicts a plan view of the optical beam member 60. Figure 12 schematically shows the waveguides 66 of the PIC for coupling optical radiation, for example, light from an external optical source (not shown) to gratings or grating couplers 61, 62, 67, 68 for emission of respective optical beams from the grating couplers. The external optical source may be a coherent source, for example, a laser source. One or more beam splitters 65 may be used for distributing or splitting incoming optical radiation between the different waveguides 66. Preferably, the PIC including the gratings are configured such that optical beams emitted by the gratings are coherent with each other.

As shown in Figure 12, a first pair of emitter arrangements 61, 62 are provided at opposite sides, in a first direction (e.g. the X direction) of the first beam aperture 63. As shown in Figure 12, in an embodiment the emitter arrangements comprise a second pair of emitter arrangements 67, 68 at opposite sides, in a second direction (e.g. the Y direction) of the first beam aperture 63. The second direction is different from the first direction. In the example shown in Figure 12, the second direction is substantially orthogonal to the first direction. The first pair of emitter arrangements 61, 62 are arranged to be orthogonal to the second pair of emitter arrangements 67, 68. The grating couplers 61, 62, 67, 68 are configured to emit in-phase optical radiation.

The arrangement in Figure 12 with the second pair of emitter arrangements 67, 68, enables better centering or alignment of the combined optical beam spot 81 in two dimensions along the surface of the sample 208 with respect to the first beam aperture 63 or the second beam aperture 266. For example, the arrangement in Figure 12 may also enable a maximization of the intensity of the combined optical beam spot such that it coincides with the electron beam spot 282. The arrangement shown in Figure 12 is merely schematic.

As can be seen from Figure 8 and Figure 11, for example, in an embodiment the aperture element (e.g. the detector substrate 264 and the detector element 266) is configured to block a line-of-sight between the electron beam spot 282 and each of the emitter arrangements 61, 62. It may be difficult or impossible for a single optical beam 71, 72 from a single emitter arrangement 61, 62 to be centred on the electron beam spot. By providing a plurality of emitter arrangements 61, 62, the combined optical beam 70 may be better centred on the electron beam spot 282.

As shown in Figure 8, for example, in an embodiment the aperture element comprises the detector element 265. The detector element 265 may face the sample 208. The detector element 265 is configured to detect electrons from the sample 208. The second beam aperture 266 may be defined in the detector element 265.

By reducing the distance between the detector element 265 and the sample 208, the detector 240 may better be able to detect signal electrons from the sample 208. In an embodiment the detector element 265 is substantially planar. In a plane of the detector element 265, a lateral dimension (e.g. diameter) of the second beam aperture 266 may be less than half a lateral dimension (e.g. diameter) of the detector element 265. By providing a relatively small second beam aperture 266, the size of the detecting surface of the detector element 265 may be desirably increased. This may help the detector 240 to detect a larger proportion of the signal electrons from the sample 208.

As shown in Figure 8, in an embodiment the emitter arrangements 61, 62 are configured to emit the optical beams 71, 72 angled relative to the electron-optical axis of the electron-optical device 230 (which may coincide with the electron-optical axis of the assembly 50). The optical beams 71, 72 may be angled relative to a direction perpendicular (or normal) to a plane containing the optical member 60. By angling the optical beams 71, 72, the optical beams may be directed through the second beam aperture 266. The emission angle may be substantially close to normal. In an embodiment, the angle between each of the optical beams 71, 72 and the electron-optical axis (i.e. the direction of the electron beam 212 or normal to the (x-y) plane containing the optical member 60) is at least one degree, optionally at least two degrees, optionally at least five degrees, and optionally at least seven degrees. In an embodiment the angle between each of the optical beams 71, 72 and the electron-optical axis is at most twenty degrees, optionally at most ten degrees, optionally at most eight degrees and optionally at most five degrees. The angle between each of the optical beams and the electron-optical axis may also be dependent on a vertical distance between the optical member 60 and the aperture element containing the second beam aperture 266. In an embodiment the emitter arrangements 61, 62 are configured to operate close to the second-order Bragg condition. The Bragg condition is $P = \dfrac{m\lambda}{2n_{eff}}$, where P is the grating period, $n_{eff}$ is the effective index of the grating coupler, $\lambda$ is the wavelength of light in vacuum, and m is an integer number that defines the "order" of the condition. In an embodiment the emitter arrangements 61, 62 are vertical emitter arrangements such as vertical grating couplers.

In an embodiment the optical member 60 is configured such that the emitter arrangements 61, 62 emit optical beams 71, 72 that are coherent with each other. In an embodiment the electromagnetic fields emitted by the emitter arrangements 61, 62 are symmetric with respect to the electron-optical axis and are in-phase with each other such that the optical beams 71, 72 constructively interfere with each other and the intensity of the resultant optical beam spot 81 on the sample is preferably maximized at the sample location where the electron beam spot 282 impinges the sample. In other embodiments, the emitter arrangements 61, 62 may be arranged adjacent the first beam aperture 63 such that the intensity of the resultant optical beam spot 81 enables voltage contrast defect detection in a scan region of the electron beam spot 282 on the sample location.

In an embodiment the assembly 50 forms part of an electron-optical device 230. For example, within the electron-optical device 230 shown in Figure 3 or the electron-optical device 230 shown in Figure 4, the assembly 50 may comprise the detector array 240. The assembly 50 may be downbeam of the objective lens array 241. For example, the optical beam member 60 may be located downbeam of the objective lens array 241 and upbeam of the detector array 240. By locating the optical beam member 60 between the objective lens array 241 and the sample 208, the optical beam member 60 may be located closer to the sample 208. By locating the optical beam member 60 close to the sample 208, the intensity of the light beam on the sample 208 may be improved.

However, it is not essential for the optical beam member 60 to be downbeam of the objective lens array 241. In an alternative arrangement, the optical beam member 60 may be placed further upbeam within the electron-optical device 230.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208. The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

Embodiments of the invention are described below in the following numbered clauses.

1. An optical beam member for a charged particle-optical device configured to direct a charged particle beam along a charged particle-optical axis of the charged particle-optical device and towards a sample location, the optical beam member comprising:

a plurality of emitter arrangements configured to emit respective optical beams towards the sample location, wherein a first beam aperture is defined in the optical beam member for passage of the charged particle beam towards the sample location;

wherein the plurality of emitter arrangements are arranged adjacent the first beam aperture and are configured to emit the respective optical beams to form a combined optical beam towards the sample location.

2. The optical beam member of clause 1, wherein the optical beam member is configured such that the plurality of emitter arrangements emit respective optical beams that are coherent with each other.

3. The optical beam member of clause 1 or 2, wherein the plurality of emitter arrangements comprise a first pair of emitter arrangements at opposite sides, in a first direction, of the first beam aperture.

4. The optical beam member of clause 3, wherein the plurality of emitter arrangements further comprise a second pair of emitter arrangements at opposite sides, in a second direction different from the first direction, of the first beam aperture.

5. The optical beam member of clause 4, wherein the second direction is orthogonal to the first direction.

6. The optical beam member of clause 4 or 5, configured such that the plurality of emitter arrangements emit respective optical beams that are in-phase with each other.

7. The optical beam member of any preceding clause, wherein the plurality of emitter arrangements are configured to emit the respective optical beams angled relative to the charged particle-optical axis of the charged particle-optical device.

8. The optical beam member of any preceding clause, wherein the optical beam member is configured such that at the sample location, an optical beam spot corresponding to the said combined optical beam is substantially proximal to a charged particle beam spot corresponding to the region where the charged particle beam impinges the sample.

9. The optical beam member of clause 8, wherein the said optical beam spot on the sample is substantially coincident with the charged particle beam spot.

10. The optical beam member of any preceding clause, wherein the plurality of emitter arrangements comprise a plurality of grating coupler arrangements configured to emit the respective optical beams.

11. The optical beam member of any preceding clause being further configured for a charged particle-optical device configured to direct a plurality of charged particle beams along respective charged particle-optical axes towards the sample location, wherein the optical beam member comprises a plurality of the first beam apertures for passage of respective charged particle beams towards the sample location.

12. The optical beam member of clause 11, wherein for each first beam aperture, the optical beam member comprises a plurality of the emitter arrangements arranged adjacent the respective first beam aperture and configured to emit the respective optical beams that form the combined optical beam towards the sample location.

13. The optical beam member of clause 11, wherein for each first beam aperture of a subset of the first beam apertures, the optical beam member comprises a plurality of the emitter arrangements arranged adjacent the respective first beam aperture and configured to emit the respective optical beams that form the combined optical beam towards the sample location.

14. An assembly for a charged particle-optical device configured to direct a charged particle beam towards a sample location, the assembly comprising:

the optical beam member of any of clauses 1-10; and

an aperture element between the optical beam member and the sample location, wherein a second beam aperture is defined in the aperture element for passage of the charged particle beam towards the sample location.

15. The assembly of clause 14, wherein the plurality of emitter arrangements are configured to emit the said respective optical beams such that the respective optical beams pass through the second beam aperture towards the sample location.

16. An assembly for a charged particle-optical device configured to direct a plurality of charged particle beams towards the sample location, wherein the assembly comprises an optical member according to any of clauses 11-13, and

an aperture element between the optical beam member and the sample location, wherein a plurality of second beam apertures are defined in the aperture element for passage of the respective charged particle beams towards the sample location.

17. The assembly of clause 16, wherein for each second beam aperture, the said plurality of emitter arrangements are further configured to emit the respective optical beams to pass through the second beam aperture towards the sample location.

18. The assembly of any of clauses 14 or 15, wherein the plurality of emitter arrangements are configured to emit the respective optical beams that form the combined optical beam, substantially at or near the second beam aperture.

19. The assembly of any of clauses 16 or 17, wherein the plurality of emitter arrangements associated with each second beam aperture are further configured to emit the respective optical beams that formed the combined optical beam, substantially at or near the corresponding second beam aperture.

20. The assembly of any of clauses 14-19, wherein the aperture element comprises a detector element facing the sample location and configured to detect charged particles from the sample location, wherein the second beam aperture is defined in the detector element.

21. The assembly of clause 20, wherein in a plane of the detector element, a lateral dimension of the second beam aperture is less than half a lateral dimension of the detector element.

22. A charged particle-optical device configured to direct a charged particle beam towards a sample location, the charged particle-optical device comprising:

the optical beam member of any of clauses 1-10; and
the assembly of any of clauses 14-15, 18 or clauses 20-21 when dependent on any of clauses 14-15, 18.

23. A charged particle-optical device configured to direct a plurality of charged particle beams towards a sample location, the charged particle-optical device comprising:
the optical beam member of any of clauses 11-13; and
the assembly of any of clauses 16-17, 19 or clauses 20-21 when dependent on any of clauses 16-17, 19.

24. The charged particle-optical device of any of clauses 22 or 23, comprising:
an objective lens configured to focus the charged particle beam onto the sample location,
wherein the optical beam member is between the objective lens and the sample location.

25. A charged particle-optical apparatus comprising:

the charged particle-optical device of any of clauses 22-24; and
an actuatable stage configured to support a sample at the sample location.

26. A method for directing optical beams towards a sample, the method comprising:

emitting, from a plurality of emitter arrangements of an optical beam member of a charged particle-optical device configured to direct a charged particle beam along a charged particle-optical axis of the charged particle-optical device and towards a sample, respective optical beams towards the sample, wherein a first beam aperture is defined in the optical beam member for passage of a charged particle beam towards the sample;
wherein the emitter arrangements are adjacent the first beam aperture and emit respective optical beams that form a combined optical beam towards the sample.

27. The method of clause 26, comprising:
directing, using the charged particle-optical device, a charged particle beam along the charged particle-optical axis and towards a sample, such that the charged particle beam passes through the first beam aperture.

28. The method of clause 26 or 27, wherein the charged particle-optical device is configured to direct a plurality of charged particle beams along respective charged particle-optical axes towards the sample location, wherein the optical beam member comprises a plurality of the first beam apertures for passage of respective charged particle beams towards the sample location,
wherein for each first beam aperture, the optical beam member comprises a plurality of the emitter arrangements arranged adjacent the respective first beam aperture and configured to emit the respective optical beams that form the combined optical beam towards the sample.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. An optical beam member for a charged particle-optical device configured to direct a charged particle beam along a charged particle-optical axis of the charged particle-optical device and towards a sample location, the optical beam member comprising:

   a plurality of emitter arrangements configured to emit respective optical beams towards the sample location, wherein a first beam aperture is defined in the optical beam member for passage of the charged particle beam towards the sample location;
   wherein the plurality of emitter arrangements are arranged adjacent the first beam aperture and are configured to emit the respective optical beams to form a combined optical beam towards the sample location.

2. The optical beam member of claim 1, wherein the optical beam member is configured such that the plurality of emitter arrangements emit respective optical beams that are coherent with each other.

3. The optical beam member of claim 1 or 2, wherein the plurality of emitter arrangements comprise a first pair of emitter arrangements at opposite sides, in a first direction, of the first beam aperture.

4. The optical beam member of any preceding claim, wherein the plurality of emitter arrangements are configured to emit the respective optical beams angled relative to the charged particle-optical axis of the charged particle-optical device.

5. The optical beam member of any preceding claim, wherein the optical beam member is configured such that at the sample location, an optical beam spot corresponding to the said combined optical beam is substantially proximal to a charged particle beam spot corresponding to the region where the charged particle beam impinges the sample.

6. The optical beam member of claim 5, wherein the said optical beam spot on the sample is substantially coincident with the charged particle beam spot.

7. The optical beam member of any preceding claim, wherein the plurality of emitter arrangements comprise a plurality of grating coupler arrangements configured to emit the respective optical beams.

8. The optical beam member of any preceding claim being further configured for a charged particle-optical device configured to direct a plurality of charged particle beams along respective charged particle-optical axes towards the sample location, wherein the optical beam member comprises a plurality of the first beam apertures for passage of respective charged particle beams towards the sample location.

9. The optical beam member of claim 8, wherein for each first beam aperture, the optical beam member comprises a plurality of the emitter arrangements arranged adjacent the respective first beam aperture and configured to emit the respective optical beams that form the combined optical beam towards the sample location.

10. The optical beam member of claim 8, wherein for each first beam aperture of a subset of the first beam apertures, the optical beam member comprises a plurality of the emitter arrangements arranged adjacent the respective first beam aperture and configured to emit the respective optical beams that form the combined optical beam towards the sample location.

11. An assembly for a charged particle-optical device configured to direct a plurality of charged particle beams towards the sample location, wherein the assembly comprises an optical member according to any of claims 8-10, and
an aperture element between the optical beam member and the sample location, wherein a plurality of second beam apertures are defined in the aperture element for passage of the respective charged particle beams towards the sample location.

12. The assembly of claim 11, wherein for each second beam aperture, the said plurality of emitter arrangements are further configured to emit the respective optical beams to pass through the second beam aperture towards the sample location.

13. A charged particle-optical device configured to direct a plurality of charged particle beams towards a sample location, the charged particle-optical device comprising:

   the optical beam member of any of claims 8-10; and
   the assembly of any of claims 11-12.

14. A charged particle-optical apparatus comprising:

   the charged particle-optical device of claim 13; and
   an actuatable stage configured to support a sample at the sample location.

15. A method for directing optical beams towards a sample, the method comprising:

   emitting, from a plurality of emitter arrangements of an optical beam member of a charged particle-optical device configured to direct a plurality of charged particle beams along respective charged particle-optical axes towards a sample location, respective optical beams towards the sample, wherein the optical beam member comprises a plurality of the first beam apertures for passage of respective charged particle beams towards the sample location; wherein for each first beam aperture, the optical beam member comprises a plurality of the emitter arrangements arranged adjacent the respective first beam aperture and configured to emit the respective optical beams that form the combined optical beam towards the sample.

# Fig. 1

Fig. 2

# Fig. 3

# Fig. 4

# Fig. 5

# Fig. 6

240

264

265

266    266

# Fig. 7

268

269

264

267

266

265

# Fig. 8

# Fig. 9

# Fig. 10

# Fig. 11

Fig. 12

Fig. 13

# Fig. 14

# Fig. 15

Europäisches Patentamt

European Patent Office

Office européen des brevets

## EUROPEAN SEARCH REPORT

**Application Number**

EP 24 21 9215

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/160959 A1 (ASML NETHERLANDS BV [NL]) 31 August 2023 (2023-08-31) <br> * abstract * <br> * paragraph [0001] - paragraph [0092] * <br> * figures 2B, 2C, 10A, 10B * <br> ----- | 1,2,4-15 | INV. <br> H01J37/22 <br> H01J37/26 <br> H01J37/28 |
|  |  |  | TECHNICAL FIELDS SEARCHED (IPC) |
|  |  |  | H01J |

The present search report has been drawn up for all claims

| Place of search | Date of completion of the search | Examiner |
|---|---|---|
| The Hague | 4 May 2025 | Bridi, Dorian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................................................

& : member of the same patent family, corresponding document

EPO FORM 1503 03.82 (P04C01)

Europäisches
Patentamt
European
Patent Office
Office européen
des brevets

**Application Number**

EP 24 21 9215

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1, 2, 4-15

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

The Search Division considers that the present European patent application does not comply with the requirements of unity of invention and relates to several inventions or groups of inventions, namely:

1. claims: 1, 2, 4-15

     The optical beam member of claim 1, wherein the optical beam member is configured such that the plurality of emitter arrangements emit respective optical beams that are coherent with each other; or wherein the plurality of emitter arrangements are configured to emit the respective optical beams angled relative to the charged particle-optical axis of the charged particle-optical device; or wherein the optical beam member is configured such that at the sample location, an optical beam spot corresponding to the said combined optical beam is substantially proximal to a charged particle beam spot corresponding to the region where the charged particle beam impinges the sample; or wherein the plurality of emitter arrangements comprise a plurality of grating coupler arrangements configured to emit the respective optical beams; or being further configured for a charged particle-optical device configured to direct a plurality of charged particle beams along respective charged particle-optical axes towards the sample location, wherein the optical beam member comprises a plurality of the first beam apertures for passage of respective charged particle beams towards the sample location; or an assembly for a charged particle-optical device configured to direct a plurality of charged particle beams towards the sample location, wherein the assembly comprises an optical member according to any of claims 8, and an aperture element between the optical beam member and the sample location, wherein a plurality of second beam apertures are defined in the aperture element for passage of the respective charged particle beams towards the sample location; or and operation method for the optical beam member of claim 1.

---

2. claim: 3

     The optical beam member of claim 1, wherein the plurality of emitter arrangements comprise a first pair of emitter arrangements at opposite sides, in a first direction, of the first beam aperture.

---

## ANNEX TO THE EUROPEAN SEARCH REPORT
## ON EUROPEAN PATENT APPLICATION NO.

EP 24 21 9215

This annex lists the patent family members relating to the patent documents cited in  the above-mentioned European search report.
The members are as contained in the European Patent Office EDP file on
The European Patent Office is in no way liable for these particulars which are merely given for the purpose of information.

04-05-2025

| Patent document cited in search report | Publication date | Patent family member(s) | Publication date |
|---|---|---|---|
| WO 2023160959 A1 | 31-08-2023 | CN 119072763 A | 03-12-2024 |
| | | TW 202343519 A | 01-11-2023 |
| | | US 2025166955 A1 | 22-05-2025 |
| | | WO 2023160959 A1 | 31-08-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022101072 A1
- WO 2012165955 A
- WO 2021156121 A1
- WO 2021204734 A1
- EP 23211553
- WO 2021156121 A
- WO 2021204734 A
- WO 2004081910 A
- EP 3869535 A1
- WO 2021165136 A1
- WO 2022058252 A1
- WO 2022008286 A1
- WO 2021165135 A1
- EP 4086933 A1